(19) Europäisches Patentamt / European Patent Office / Office européen des brevets

(11) **EP 4 516 429 A1**

(12) **EUROPEAN PATENT APPLICATION**
published in accordance with Art. 153(4) EPC

(43) Date of publication:
**05.03.2025 Bulletin 2025/10**

(21) Application number: **23796192.5**

(22) Date of filing: **18.04.2023**

(51) International Patent Classification (IPC):
*B22F 9/00* (2006.01)    *B22F 1/00* (2022.01)
*B22F 1/052* (2022.01)    *B22F 1/065* (2022.01)
*B22F 1/102* (2022.01)    *B22F 7/08* (2006.01)
*H01L 21/52* (2006.01)

(52) Cooperative Patent Classification (CPC):
**B22F 1/00; B22F 1/052; B22F 1/065; B22F 1/102;**
**B22F 7/08; B22F 9/00; H01L 21/52**

(86) International application number:
**PCT/JP2023/015511**

(87) International publication number:
**WO 2023/210449 (02.11.2023 Gazette 2023/44)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **28.04.2022 JP 2022075061**

(71) Applicant: **Mitsui Mining & Smelting Co., Ltd.**
**Shinagawa-ku**
**Tokyo 141-8584 (JP)**

(72) Inventors:
• **KONNO, Satoshi**
  **Ageo-shi, Saitama 362-0021 (JP)**
• **YAMAUCHI, Shinichi**
  **Ageo-shi, Saitama 362-0021 (JP)**
• **ANAI, Kei**
  **Ageo-shi, Saitama 362-0021 (JP)**

(74) Representative: **Novagraaf Technologies**
**Bâtiment O2**
**2, rue Sarah Bernhardt**
**CS90017**
**92665 Asnières-sur-Seine Cedex (FR)**

(54) **COPPER PASTE FOR JOINING, METHOD FOR JOINING BODY TO BE JOINED, METHOD FOR PRODUCING JOINED BODY, AND METHOD FOR PRODUCING COPPER PASTE FOR JOINING**

(57)     An object is to provide a copper paste for joining that is unlikely to generate voids in a sintering process of a coating film formed thereof to achieve a sufficiently high joining rate to a target member to be joined. A copper paste for joining contains: two or more copper powders having different particle sizes; and a solvent; wherein one of the copper powders has an increase rate of a crystallite size, $(D2-D1)/D1 \times 100$, of 5% or more, where D1 (nm) represents a crystallite size at 150°C and D2 (nm) represents a crystallite size at 250°C; the solvent has a boiling point of 150°C or higher and lower than 300°C; and the proportion of the total amount of the copper powders is 88 mass% or more in 100 mass% of the copper paste.

EP 4 516 429 A1

**Description**

Technical Field

The present invention relates to a copper paste for joining. Also, the present invention relates to a method for joining target members to be joined with the copper paste for joining, a method for producing a joined body, and a method for producing the copper paste for joining.

Background Art

In recent years, a paste containing a sinterable metal powder has been used as an alternative joining material to solder. For example, Patent Literature 1 discloses a copper paste for joining, the paste containing sub-micro copper particles having a volume-average particle size of 0.12 $\mu$m or more and 0.8 $\mu$m or less and micro copper particles having a volume-average particle size of 2 $\mu$m or more and 50 $\mu$m or less.

Citation List

Patent Literature

Patent Literature 1: US 2018/0250751A1

Summary of Invention

The above-mentioned paste contains two types of copper particles and a solvent. To join two target members with this paste, a coating film formed of the paste is disposed between the two target members, and in this state, the coating film is sintered. In the process of sintering the coating film, the solvent contained in the coating film is volatilized and removed as the temperature increases. If the solvent is not successfully removed, spaces, so-called voids, are formed in the coating film, which makes it difficult to achieve a sufficient joining rate of the resulting joining layer to the target member. As a result, a sufficient joining strength of the joining layer to the target member may not be achieved disadvantageously. Such a problem is serious when the target members have a large joining area or when the joining is performed in a pressureless state.

Therefore, an object of the present invention is to provide a copper paste for joining that is unlikely to generate voids in a sintering process of a coating film formed thereof to achieve a sufficiently high joining rate to a target member to be joined.

The present invention provides a copper paste for joining, containing: two or more copper powders having different particle sizes; and a solvent,

wherein one of the copper powders has an increase rate of a crystallite size, (D2-D1)/D1×100, of 5% or more, where D1 (nm) represents a crystallite size at 150°C and D2 (nm) represents a crystallite size at 250°C,
the solvent has a boiling point of 150°C or higher and lower than 300°C, and
a proportion of a total amount of the copper powders is 88 mass% or more in 100 mass% of the copper paste.

The present invention also provides a method for joining target members to be joined, the method including:

laying two target members on top of each other with a joining area of more than 4 mm$^2$ via the copper paste for joining, and
sintering the copper paste in a pressureless state to join the two target members.

The present invention also provides a method for producing a joined body, the method including:

laying two target members to be joined on top of each other with a joining area of more than 4 mm$^2$ via the copper paste for joining, and
sintering the copper paste in a pressureless state to join the two target members.

The present invention also provides a method for producing a copper paste for joining, the method including mixing copper powders and a solvent,

wherein the copper powders include: a first copper powder having an increase rate of a crystallite size, (D2-D1)/D1×100, of 5% or more, where D1 (nm) represents a crystallite size at 150°C and D2 (nm) represents a crystallite size at 250°C; and a second copper powder having a different particle size from the first copper powder, the solvent has a boiling point of 150°C or higher and lower than 300°C, and a proportion of a total amount of the copper powders is 88 mass% or more in 100 mass% of the copper paste for joining.

Description of Embodiments

Hereinafter, the present invention will be described based on preferred embodiments thereof.

A copper paste for joining (hereinafter also referred to as "paste") of the present invention contains two or more copper powders having different particle sizes and a solvent, and may optionally contain a modifier.

There is no particular limitation on the shape of particles of the copper powders contained in the paste, and the copper powders may have a spherical particle shape or a non-spherical particle shape. Here, the phrase "a copper powder has a spherical particle shape" means that particles of the copper powder have a circularity coefficient of 0.85 or more. The circularity coefficient is determined in the following manner: a scanning electron microscope image of a primary particle of the copper powder is captured; and the circularity coefficient is calculated using the expression: $4\pi S/L^2$, where S represents the area of a two-dimensional projection image of the particle of the copper powder, and L represents the perimeter length thereof.

On the other hand, the phrase "a copper powder has a non-spherical particle shape" means that the above-described circularity coefficient is less than 0.85. Specific examples of the non-spherical particle shape include a flat shape, a polyhedral shape such as a hexahedron and an octahedron, a fusiform shape, and an irregular shape.

In the present invention, the term "flat shape" refers to a shape that has a pair of planar surfaces as the major surfaces of the particle and a side surface orthogonal to the planar surfaces, and the planar surfaces and the side surface may each independently be a flat surface, a curved surface, or an uneven surface.

The present invention contains two or more copper powders having different particle sizes. When copper powders having different particle sizes are used, particles of a copper powder having a smaller particle size enter gaps between particles of a copper powder having a larger particle size, and thus, the density of the copper powders in the paste is increased. As a result, when the paste is disposed between two target members to be joined (hereinafter also referred to as "joining target member") and sintered, sintering of the copper powders sufficiently proceeds to thereby increase the joining rate of the copper powder particles to each other, and consequently, the joining rate of the resulting joining layer to the joining target member is also increased. Thus, the two joining target members can be sufficiently joined to each other, even in a pressureless state.

Preferably, all of the two or more copper powders each have a spherical particle shape. When all the copper powders each have a spherical particle shape, the packing density of the copper powders can be increased in a joining layer to be obtained by sintering the paste between joining target members. In addition, when the paste is disposed between two joining target members and sintered, sintering of the copper powders proceeds even more sufficiently, so that the two joining target members can be sufficiently joined to each other even in a pressureless state.

The particle size of the copper powder having a spherical particle shape is determined by the following method. Specifically, observation images of the copper powder are obtained under a scanning electron microscope at a magnification within a range of 10,000x or more and 150,000x or less; in the observation images, 50 or more primary particles of the copper powder with well-defined contours are selected; the Heywood diameter is measured for each of the selected particles; the volumes of the particles are calculated from the Haywood diameters, assuming that the particles have a perfect spherical shape, and the cumulative volume-based particle size at a cumulative volume of 50 vol% in the volumes obtained from the calculation is determined, which is designated as the particle size $D_{SEM50}$.

When the copper powders include the first and second copper powders each having a spherical particle shape, the particle size of the first copper powder, d1, is preferably 0.11 μm or more and less than 1 μm, more preferably 0.11 μm or more and 0.8 μm or less, and even more preferably 0.11 μm or more and 0.6 μm or less.

The particle size of the second copper powder, d2, is preferably 1 μm or more and 10 μm or less, more preferably 1 μm or more and 8 μm or less, and even more preferably 1 μm or more and 6 μm or less.

The ratio between the particle sizes $D_{SEM50}$ of the first copper powder and the second copper powder, or specifically, the ratio of the particle size of the second copper powder, d2, to the particle size of the first copper powder, d1, (i.e., d2/d1) is preferably 2 or greater and 90 or less, more preferably 4 or greater and 70 or less, and even more preferably 6 or greater and 50 or less.

When a paste containing the two copper powders having different particle sizes so as to satisfy the above-described ratio is applied to a joining target member and sintered to form a joining layer, cracking due to shrinkage is unlikely to occur, so that a fillet portion of the joining layer can be sufficiently joined to the joining target member.

As one of the two or more copper powders, a copper powder is used that has an increase rate of the crystallite size, (D2-D1)/D1×100, of 5.0% or more, preferably 7.5% or more, and more preferably 8.0% or more, where D1 (nm) represents the crystallite size at 150°C and D2 (nm) represents the crystallite size at 250°C. When such a condition is satisfied, the copper powders constituting the paste exhibits improved sinterability, and thus, when the paste is disposed between two joining target members and sintered, sintering of the copper powders proceeds even more sufficiently to suppresses void formation, so that the two joining target members can be joined at a high joining rate even in a pressureless state. Therefore, the paste is favorably used to join target members that have a large joining area as described later, which are greatly affected by void formation.

Hereinafter, the increase rate of the crystallite size will be also referred to as "crystallite size increase rate", and this term means a value calculated from "(D2-D1)/D1×100". There is no particular limitation on the upper limit value of the crystallite size increase rate, and the upper limit value can be about 100%.

No special production method is required to obtain a copper powder having a crystallite size increase rate of 5% or more, and the crystallite size increase rate can be controlled by the type of copper source, the type of an organic surface treatment agent, the type of a reducing agent, the type of an organic solvent, and others used to produce the copper powder, as well as by the reaction time and the reaction temperature in production of the copper powder. Alternatively, a copper powder having a crystallite size increase rate of 5% or more may be selected as appropriate from widely available copper powders and used.

The crystallite size of a copper powder is determined by analyzing an X-ray diffraction pattern obtained through XRD based on a high-temperature XRD (X-ray powder diffractometry) and then performing calculation using the Scherrer equation.

The high-temperature XRD refers to a method in which a sample is placed in a high-temperature unit capable of heating the sample, and XRD is performed while gradually heating the sample. The XRD is performed by using a fully-automated horizontal multipurpose X-ray diffractometer manufactured by Rigaku Corporation and, as a detector, a high-speed two-dimensional X-ray detector PILATUS 100K/R manufactured by Rigaku Corporation. The conditions for obtaining the X-ray diffraction pattern are as follows.

Optical system: Parallel beam
X-ray source: CuK$\alpha$ radiation
Measurement mode: Still mode $2\theta = 42°$ fixed (X-ray diffraction intensity corresponding to $2\theta = 38°$ to 48° is obtained by the above two-dimensional detector)
Exposure time: 60 seconds
Collimator: $\Phi$ 0.2 mm
Measurement atmosphere: Nitrogen
Measurement temperature: 150°C and 250°C
Temperature increase rate: 10°C/min
During XRD (exposure time: 60 seconds) at each measurement temperature, the measurement temperature is maintained without temperature increase.

Next, the crystallite size is calculated, using the Scherrer equation below, from the half-width of an X-ray diffraction pattern of the (111) crystal plane of the copper powder obtained by the above-described XRD.

$$\text{Scherrer equation: } D = K\lambda/\beta\cos\theta$$

D: Crystallite size
K: Scherrer constant (0.94)
$\lambda$: Wavelength of X-ray
$\beta$: Half width [rad]
$\theta$: Bragg angle [rad]

The proportion of the copper powder having a crystallite size increase rate of 5% or more is preferably 10 mass% or more and 80 mass% or less, and more preferably 20 mass% or more and 70 mass% or less, in the total amount of the copper powders. This suppresses void formation to improve the sinterability of the copper powders, so that two joining target members can be joined at a high joining rate. Also, the two joining target members can be sufficiently joined to each other even in a pressureless state. No special production method is required to obtain a copper powder having a crystallite size increase rate of 5% or more, and a copper powder having a crystallite size increase rate of 5% or more can be selected as appropriate from widely available copper powders. Examples of such a copper powder include CH-0200 and CH-0200L1 manufactured by Mitsui Mining & Smelting Co., Ltd.

The particles of the copper powders may have a surface treatment agent applied to their surfaces. The surface treatment agent applied to the surfaces of the particles of the copper powders can suppress excessive aggregation of the copper powder particles.

Examples of the surface treatment agent suitably used in the present invention for suppressing aggregation of the copper powder particles include various types of fatty acids, aliphatic amines, and complexing agents having affinity for copper. **In** particular, it is preferable to use a saturated or unsaturated fatty acid or aliphatic amine having 6 to 18 carbon atoms, especially, 10 to 18 carbon atoms, or a copper salt thereof, in view of improving oxidation resistance. Specific examples of such fatty acids and aliphatic amines include benzoic acid, pentanoic acid, hexanoic acid, octanoic acid, nonanoic acid, decanoic acid, lauric acid, palmitic acid, oleic acid, stearic acid, pentylamine, hexylamine, octylamine, decylamine, laurylamine, oleylamine, and stearylamine. Examples of the complexing agent having affinity for copper include amino acids such as glycine, and dimethylglyoxime. The fatty acids, the aliphatic amines, and the complexing agents listed above may be used singly or in a combination of two or more.

In the present invention, it is preferable to use a solvent having a boiling point of 150°C or higher and lower than 300°C. When such a solvent is used, the solvent remains until a predetermined temperature is reached during sintering of the paste, and thus, void formation due to bumping or the like can be suppressed. Also, gas release occurs gently, and thus, void formation can be suppressed. Furthermore, a liquid bridge force acts between the copper particles in the solvent, and thus, an adhesive force acts between adjacent copper particles.

As a result, when the paste is applied to a joining target member and sintered, the resulting joining layer has reduced voids, so that the joining rate of the joining layer (that is, the sintered copper particles) to the joining target member is high. Thus, two joining target members can be joined with a sufficient joining strength, even in a pressureless state. In light of this, the paste of the present invention is favorably used to join target members having a joining area of more than 4 $mm^2$ (or in other words, to join target members that are to be joined to each other via a joining area of more than 4 $mm^2$).

From the same viewpoint, it is preferable that the solvent should not contain a solvent having a boiling point of 300°C or higher.

Examples of the solvent having a boiling point of 150°C or higher and lower than 300°C include monohydric alcohols, polyhydric alcohols, ketones, ethers, polyhydric alcohol alkyl ethers, polyhydric alcohol aryl ethers, aliphatic organic acids, esters, nitrogen-containing heterocyclic compounds, amides, amines, and saturated hydrocarbons. These solvents may be used singly or in a combination of two or more. Among these solvents, it is preferable to use at least one selected from alcohols such as propylene glycol, ethylene glycol, hexylene glycol, diethylene glycol, 1,3-butanediol, 1,4-butanediol, dipropylene glycol, tripropylene glycol, terpineol, and dihydroterpineol, ethers such as ethyl carbitol and butyl carbitol, and aliphatic organic acids, and an aliphatic organic acid is particularly preferably used. The reason for this is as follows: use of such a solvent enables removal of an oxide film that may exist on the surface of particles the copper powders, thereby allowing highly active copper powder particles to be deposited before sintering, and it is therefore easy to obtain a joined body while preventing increase in electric resistance thereof.

Examples of the aliphatic organic acids include carboxylic acids. Examples of the carboxylic acids include primary, secondary, and tertiary carboxylic acids each having a branched chain. A secondary or tertiary carboxylic acid is preferably used, and a tertiary carboxylic acid is more preferably used.

When such a carboxylic acid is used, appropriate dispersibility of the particles can be maintained due to the bulkiness of the molecular structure of the carboxylic acid, so that void formation is more likely to be suppressed during sintering of the copper powders, and accordingly, the joining rate to the joining target member is increased. In addition, the copper paste can have sufficiently improved sinterability, and it is thus easy to obtain a joining layer that has both high levels of joining rate and joining strength to the joining target members.

Examples of a carboxylic acid suitable for the present invention include branched and saturated aliphatic monocarboxylic acids such as isobutyric acid, pivalic acid, 2,2-methylbutyric acid, isopentanoic acid, isohexanoic acid, isoheptanoic acid, isooctanoic acid, isononanoic acid, isodecanoic acid, and neodecanoic acid; branched and unsaturated aliphatic monocarboxylic acids such as methacrylic acid; and unsaturated tricarboxylic acids such as aconitic acid. These carboxylic acids may be used singly or in combination.

The proportion of the total amount of the copper powders in the paste is preferably 88 mass% or more, more preferably 92 mass% or more, and even more preferably 95 mass% or more, and may be 96 mass% or more. The proportion of the total amount of the copper powders in the paste is more preferably 98 mass% or less. When the proportion of the copper powders in the paste is within the above-described range, the proportion of the copper powders in the paste is large while the proportion of the solvent is small; void formation is thus suppressed, so that the joining rate of the copper powders to the joining target member (in other words, the joining rate of the joining layer formed by sintering the copper powders to the joining target member) is increased, and the contact area therebetween is thus increased. Accordingly, two joining target members can be sufficiently joined to each other, even in a pressureless state, and even when two joining target members have a joining area as large as more than 4 $mm^2$, the two joining target members can be joined with a sufficiently large joining strength.

As described above, the two copper powders constituting the paste both may have a spherical particle shape, and the ratio of the particle size of the second copper powder, d2, to the particle size of the first copper powder, d1, (i.e., the ratio d2/d1) may be within a range of 2 or greater and 90 or less, preferably 6 or greater and 50 or less. Accordingly, the paste has favorable coating properties even though the paste has a high copper powder concentration as described above.

In view of enhancing the ease of application or printability of the paste, the viscosity of the paste is preferably 10 Pa·s or more, and more preferably 15 Pa·s or more, as measured at a shear rate of 10 s$^{-1}$. The viscosity of the paste is preferably 800 Pa·s or less, and more preferably 700 Pa·s or less, and may be 200 Pa·s or less, as measured at a shear rate of 10 s$^{-1}$. The viscosity is measured using a rheometer (viscoelasticity measuring instrument).

The viscosity of the paste can be measured using a rheometer MARS III manufactured by Thermo Scientific, Inc. The conditions for measuring the viscosity of the paste are as follows.

Measurement mode: Shear rate dependent measurement
Sensor: Parallel type (Φ 20 mm)
Measurement temperature: 25°C
Gap: 0.300 mm
Shear rate: 0.05 to 120.01 s$^{-1}$
Measurement time: 2 minutes

As described above, the paste may contain modifiers for modifying various characteristics as appropriate. Examples of the modifiers include a reducing agent, a viscosity modifier, and a surface tension modifier.

As the reducing agent, those that promote sintering of the copper powders are preferable, and examples thereof include monohydric alcohols, polyhydric alcohols, amino alcohols, citric acid, oxalic acid, formic acid, ascorbic acid, aldehyde, hydrazine and its derivatives, hydroxylamine and its derivatives, dithiothreitol, phosphite, hydrophosphite, and phosphorous acid and its derivatives.

As the viscosity modifier, those that can adjust the viscosity level of the paste, preferably so as to be within the above-described range, are preferable, and examples thereof include ketones, esters, alcohols, glycols, hydrocarbons, and polymers.

Examples of the surface tension modifier include polymers such as acrylic surfactants, silicone-based surfactants, alkyl polyoxyethylene ethers, and fatty acid glycerol esters, and also monomers such as alcohol-based surfactants, hydrocarbon-based surfactants, ester-based surfactants, and glycol.

There is no particular limitation on the types of the joining target members. In general, the joining target member preferably contains a metal in its surface to be joined. For example, at least one of the two joining target members may be a member having a surface made of a metal. As used herein, the term "metal" refers to a metal as such, which is not combined with another element to form a compound, or an alloy of two or more metals. Examples of such a metal include copper, silver, gold, aluminum, palladium, nickel, and an alloy of a combination of two or more thereof.

In the case where at least one of the two joining target members is a member having a surface made of a metal, the surface made of a metal may be made of one metal or two or more metals. In the case where the surface is made of two or more metals, the surface may be made of an alloy. In general, the surface made of a metal is preferably a flat surface, but may be curved, if necessary.

Specific examples of the joining target members include a spacer and a heat dissipation plate made of any of the above-listed metals, a semiconductor element, and a substrate containing at least one of the above-listed metals in its surface. Examples of the substrate include an insulating substrate having a ceramic or aluminum nitride plate and a metal layer thereon, the layer made of a metal such as copper. In the case where a semiconductor element is used as a joining target member, the semiconductor element contains one or more elements selected from the group consisting of Si, Ga, Ge, C, N, and As. Preferably, one of the two joining target members is a substrate. Preferably, the other joining target member is a spacer, a heat dissipation plate, or a semiconductor element.

Alternatively, a dried product formed from a paste containing metal fine particles and a solvent may be used at least one of the two joining target members. Specifically, a member having a surface made of a metal may be used as one of the two joining target members, while a dried product formed from a paste containing metal fine particles and a solvent is used as the other joining target member. In the case where a dried product formed from a paste is used, the dried product is preferably obtained by applying the paste to a support member made of a metal such as copper and drying the paste.

Next, a preferred method for joining target members to be joined will be described.

First, the paste is applied to the first joining target member to form a coating film (coating film-forming step). The first joining target member may be any joining target member described above, and preferably, the first joining target member is a spacer or heat dissipation plate made of any of the above-listed metals, a semiconductor element, a substrate containing at least one of the above-listed metals in its surface, for example.

After the coating film has been formed on the surface of the first joining target member, a second joining target member is placed on the coating film to form a stack in which the first joining target member, the coating film, and the second joining target member are stacked in this order (stack-forming step). The second joining target member may be any of those mentioned above for the first joining target member, without limitation.

In the case where the first joining target member is a substrate, the second joining target member is preferably a spacer, a heat dissipation plate, or a semiconductor element, for example. In the present invention, since the first joining target member and the second joining target member are joined to each other with the paste described above, void formation can be suppressed during the joining, and therefore, the present method is favorably used when the joining target members have a joining area of more than 4 mm$^2$. Significantly, the present method suppresses void formation even when the joining area is 25 mm$^2$ or more, in which case the problem of void formation is otherwise particularly serious. The upper limit of the joining area is not particularly limited, and may be 900 mm$^2$, for example.

The stack formed as described above is subjected to the first heating step. In this step, heating of the stack is generally started from room temperature or around it to remove the solvent contained in the coating film. In this step, the copper particles contained in the coating film are not sintered.

In this step, the stack is heated gradually (first heating step). As used herein, the phrase "heated gradually" means that heating is performed such that the temperature continuously increases from the start of heating in the first heating step until the maximum temperature, which will be described later, is reached. After the maximum temperature is reached, the temperature may be kept (e.g., for 10 minutes or longer and 120 minutes or shorter). In the first heating step, it is acceptable that the heating temperature is constant or decreases temporarily.

The gradual heating in the first heating step is advantageous because of the following: since the solvent contained in the coating film can be removed slowly, voids are less likely to be formed when the copper particles are sintered in a second heating step, which will be described later.

The heating in this step may be performed such that the temperature increases linearly, exponentially, or logarithmically, with respect to time, or in a combined manner of these temperature increase modes. Regardless of the temperature increase mode, it is preferable that heating should be performed in an inert atmosphere in a pressureless state. The phrase "in a pressureless state" as used herein refers to a state in which no external force, except for the weight of the second joining target member, acts between the first joining target member and the second joining target member in the above-described stack. In addition, the first heating in an inert atmosphere, which is synergistically combined with the second heating in an atmosphere described later, can effectively suppress the formation of voids in a sintered body formed through sintering. In contrast to this, if the first heating step is performed in a reducing atmosphere, removal of the solvent from the coating film and sintering of the copper particles in the coating film proceed simultaneously, and therefore, voids are more likely to be formed in the sintered body.

The inert atmosphere used in the first heating step may be, for example, a nitrogen gas atmosphere, or a rare gas atmosphere such as argon or neon. From an economical viewpoint, it is preferable to use a nitrogen gas atmosphere. The inert atmosphere used in the present heating step does not contain any non-inert gas, except for that unavoidably mixed therein, and examples of the non-inert gas include reducing gases such as hydrogen gas, and oxidizing gases such as oxygen gas and air.

In the first heating step, the stack is preferably heated at a temperature increase rate of 0.01°C/s or more and 1°C/s or less, because this allows the solvent contained in the coating film to be removed slowly. In view of making this advantage even more distinct, the temperature increase rate in heating in this step is more preferably 0.01°C/s or more and 0.8°C/s or less, and even more preferably 0.01°C/s or more and 0.6°C/s or less.

In the case where the temperature increase rate in the first heating step is not constant, the average value of temperature increase rates may be within the above-described range.

The end temperature of the first heating step, or in other words, the maximum temperature in the first heating step is preferably 110°C or higher and Bp°C or lower, where Bp represents the boiling point of the solvent contained in the copper paste. This allows the solvent and moisture absorbed by the copper paste to volatilize well, and thus, void formation is more likely to be suppressed. In view of making this advantage more distinct, the lower limit of the maximum temperature in the first heating step is preferably 140°C, and more preferably 160°C.

Particularly, in the case where the solvent contained in the copper paste is an aliphatic organic acid, the maximum temperature of heating in the first heating step is preferably 240°C or lower, in view of suppressing void formation due to rapid evaporation of solvent components.

The stack after the first heating step is then subjected to the second heating step (second heating step). In this step, the stack is heated to a temperature higher than or equal to the heating temperature in the first heating step, to thereby sinter the copper particles in the coating film to form a sintered body, that is, a joining layer.

The second heating step is distinguished from the above-described first heating step by the difference in atmosphere. More specifically, the atmosphere used in the first heating step is an inert atmosphere, whereas the atmosphere used in the second heating step is a reducing atmosphere. Thus, the formation of voids in the sintered body is effectively suppressed by using a combination of an inert atmosphere and a reducing atmosphere, in the present production method.

The reducing atmosphere used in the second heating step is an atmosphere in which a reducing gas is contained. Examples of the reducing gas include hydrogen, formic acid, carbon monoxide, and ammonia. These reducing gases may be used singly, or in combination of two or more thereof. Among these reducing gases, a formic acid-containing gas is preferably used for the following reason: when a formic acid-containing gas is used, the oxide film on the surface of the copper particles is easily removed by the formic acid, and the surface activity of the copper particles is thus increased, which facilitates sintering between the copper particles at low temperatures.

The reducing atmosphere used in the second heating step may contain only the reducing gas, or may contain the reducing gas and also an additional gas. An example of the additional gas is the inert gas mentioned above for the first heating step. Specifically, nitrogen gas and noble gases can be used, for example. In the case where the reducing atmosphere used in the second heating step is a mixed atmosphere of a reducing gas and an inert gas, the reducing gas concentration of the mixed atmosphere is preferably 1 vol% or more, and more preferably 2 vol% or more. Such a concentration facilitates the removal of the oxide film on the surface of the copper particles by the reducing gas such as formic acid, and the surface activity of the copper particles is thus increased, which facilitates sintering between the copper particles at low temperatures.

The temperature change in the second heating step is preferably -0.1°C/s or more and 1.0°C/s or less, and more preferably -0.1°C/s or more and 0.5°C/s or less, provided that the heating temperature in the second heating step is higher than or equal to the heating temperature in the first heating step. Such a temperature change allows sintering to proceed successfully without uneven sintering. In view of making this advantage even more distinct, the temperature increase rate in the second heating step is more preferably -0.1°C/s or more and 0.3°C/s or less.

In the case where the temperature change in the second heating step is not constant, the average value of temperature change rates may be within the above-described range. For the sake of clarity, the above-described range of the temperature change includes 0°C/s.

The maximum temperature in heating in the second heating step is preferably 250°C or lower, in view of suppressing void formation that may be otherwise caused by volatilization the remaining solvent all at once. The heating time in the second heating step is preferably 10 minutes or longer and 180 minutes or shorter.

As a result of subjecting the stack to the second heating step, the coating film made of the paste is formed into a sintered body, so that the first joining target member and the second joining target member are joined to each other via the sintered body. Thus, the intended joined body is obtained. The completion of the second heating step, or in other words, the start of the cooling step is caused by switching the atmosphere in the system to an inert atmosphere and lowering the temperature in the system. To lower the temperature in the system, heating may be stopped to allow the system to cool naturally, or a cooling gas (this is an inert gas) may be passed through the system, for example. It is preferable to maintain the inert atmosphere in the system during the cooling step, in view of preventing oxidation of the joined body. The type of the inert atmosphere may be the same as that used in the first heating step.

The heating in the second heating step is performed in a pressureless state. The meaning of the phrase "in a pressureless state" here is as described above.

Void formation that may otherwise occur in the film sintering process is suppressed by using the paste of the present invention in the above-described manner, and a high joining rate of the joining layer is thus achieved. As a result, a sufficiently high joining strength between the joining target members can be obtained. Furthermore, as a secondary effect of the high joining rate, excellent thermal and electrical properties can also be obtained.

The paste of the present invention as described above can be favorably used in, for example, an in-vehicle electronic circuit, and an electronic circuit in which a power device is mounted.

With respect to the above-described embodiments, the present invention further discloses a copper paste for joining, a method for joining target members to be joined, a method for producing a joined body, and a method for producing a copper paste for joining, as described below.

(1) A copper paste for joining, containing two or more copper powders having different particle sizes and a solvent,

wherein one of the copper powders has an increase rate of a crystallite size, $(D2-D1)/D1 \times 100$, of 5% or more, where D1 (nm) represents a crystallite size at 150°C and D2 (nm) represents a crystallite size at 250°C, the solvent has a boiling point of 150°C or higher and lower than 300°C, and a proportion of a total amount of the copper powders is 88 mass% or more in 100 mass% of the copper paste.

(2) The copper paste for joining as set forth in clause (1), wherein all the copper powders each have a spherical particle shape.

(3) The copper paste for joining as set forth in clause (2),

wherein the copper powders include a first copper powder having a particle size d1 and a second copper powder having a particle size d2, and a ratio the particle size of the second copper powder to the particle size of the first copper powder, d2/d1, is 2 or greater and 90 or less.

(4) The copper paste for joining as set forth in any one of clauses (1) to (3), wherein a proportion of the copper powder having an increase rate of the crystallite size, (D2-D1)/D1×100, of 5% or more is 10 mass% or more and 80 mass% or in 100 mass% of the total amount of the copper powders.

(5) The copper paste for joining as set forth in any one of clauses (1) to (4), wherein the proportion of the total amount of the copper powders is 92 mass% or more in 100 mass% of the copper paste.

(6) The copper paste for joining as set forth in any one of clauses (1) to (5), wherein the copper paste is free from a solvent having a boiling point of 300°C or higher.

(7) The copper paste for joining as set forth in any one of clauses (1) to (6), having a viscosity of 10 Pa·s or more and 800 Pa·s or less, as measured at a shear rate of 10 s$^{-1}$.

(8) The copper paste for joining as set forth in any one of clauses (1) to (7), for joining target members to be joined having a joining area of more than 4 mm$^2$.

(9) The copper paste for joining as set forth in any one of clauses (1) to (8), for joining in a pressureless state.

(10) A method for joining target members to be joined, the method including:

laying two target members on top of each other with a joining area of more than 4 mm$^2$ via the copper paste for joining as set forth in any one of clauses (1) to (9), and
sintering the copper paste in a pressureless state to join the two target members.

(11) A method for producing a joined body, the method including:

laying two target members to be joined on top of each other with a joining area of more than 4 mm$^2$ via the copper paste for joining as set forth in any one of clauses (1) to (9), and
sintering the copper paste in a pressureless state to join the two target members.

(12) A method for producing a copper paste for joining, the method including mixing copper powders and a solvent,

wherein the copper powders include: a first copper powder having an increase rate of a crystallite size, (D2-D1)/D1×100, of 5% or more, where D1 (nm) represents a crystallite size at 150°C and D2 (nm) represents a crystallite size at 250°C; and a second copper powder having a different particle size from the first copper powder, the solvent has a boiling point of 150°C or higher and lower than 300°C, and
a proportion of a total amount of the copper powders is 88 mass% or more in 100 mass% of the copper paste for joining.

Examples

Hereinafter, the present invention will be described in further detail by way of examples. However, the scope of the present invention is not limited to the examples given below. Unless otherwise specified, "%" means "mass%".

Example 1

(1) Preparation of Paste

As copper powders, the first copper powder having a spherical particle shape and an average primary particle size $D_{SEM50}$ of 0.14 μm (CH-0200L1, manufactured by Mitsui Mining & Smelting Co., Ltd.) and the second copper powder having a spherical particle shape and an average primary particle size $D_{SEM50}$ of 2.2 μm (CS20, manufactured by Mitsui Mining & Smelting Co., Ltd.) were used. The two copper powders were mixed in a mass ratio of first copper powder: second copper powder = 30:70. The ratio of the particle size of the second copper powder to the particle size of the first copper powder was 15.7.

The first copper powder had a crystallite size increase rate, (D2-D1)/D1×100, of 10.1%, where D1 (nm) represents the crystallite size at 150°C and D2 (nm) represents the crystallite size at 250°C.

As a solvent, neodecanoic acid (Versatic 10, manufactured by Hexion; boiling point: 270°C or higher and 280°C or lower) was used.

Neodecanoic acid was added in an amount of 7.5% in 100% copper paste (i.e., 92.5% copper powders in 100% copper paste), and the resulting mixture was preliminary kneaded with a spatula. Then, the kneaded product was made into a paste by performing two cycles of processing using a rotation-revolution vacuum mixer (ARE-500, manufactured by Thinky Corporation), wherein one cycle consisted of an agitation mode (1000 rpm × 1 minute) and a defoaming mode (2000 rpm × 30 seconds). The paste was further allowed to pass through a three-roll mill for further dispersing and mixing, whereby a copper paste of Example was prepared.

(2) Application to First Joining target member

A copper lead frame (thickness: 2.0 mm) was used as the first joining target member. The copper paste was applied by screen printing to the area of the copper lead frame where a chip would be mounted, to thereby form a coating film. The coating film had a rectangular shape of 6 mm × 10 mm. The coating film had a thickness of 100 $\mu$m.

(3) Production of Stack

A 5 mm square SiC chip (thickness: 0.2 mm) as a second joining target member was placed on the coating film, and the thickness of the coating film was adjusted to 50 $\mu$m using a Digimatic Indicator (manufactured by Mitutoyo Corporation).

(4) First Heating Step

The stack was placed in a heating furnace. 100% nitrogen gas was allowed to flow through the heating furnace. The flow rate of the nitrogen gas was 3 L/min. In this state, the stack was heated from room temperature (25°C) to 200°C, and the temperature was maintained for 10 minutes after reaching 200°C. The temperature was increased linearly with respect to time, and the temperature increase rate was 0.1°C/sec. The heating of the stack was performed in a pressureless state.

(5) Second Heating Step

After the inside of the heating furnace had been maintained at 200°C for 10 minutes, the gas flowing through the heating furnace was switched to a reducing gas. The temperature increase was stopped, and the temperature in the heating furnace was maintained at 200°C. Nitrogen gas containing 3 vol% formic acid was used as the reducing gas. The flow rate of the reducing gas was 0.5 L/min. In this step, the temperature in the heating furnace was maintained constant at 200°C for 60 minutes. The heating of the stack was performed in a pressureless state.

(6) Cooling Step

After the second heating step had been performed for 60 minutes, the gas flowing through the heating furnace was switched to 100% nitrogen gas. Also, heating in the heating furnace was stopped. Then, the inside of the heating furnace was cooled, and after the temperature in the furnace lowered to room temperature, the joined body was taken out of the furnace.

Example 2

A joined body was obtained in the same manner as in Example 1, except that neodecanoic acid was added such that the proportion of the total amount of the first copper powder and the second copper powder was 92.0% in 100% paste.

Example 3

A joined body was obtained in the same manner as in Example 1, except that neodecanoic acid was added such that the proportion of the total amount of the first copper powder and the second copper powder was 90.0% in 100% paste.

Example 4

A joined body was obtained in the same manner as in Example 1, except that neodecanoic acid was added such that the proportion of the total amount of the first copper powder and the second copper powder was 88.0% in 100% paste.

Example 5

A joined body was obtained in the same manner as in Example 1, except that the time for which the temperature was maintained at 200°C in (5) Second Heating Step was changed from 60 minutes to 120 minutes, and that the operations in (2) Application to First Joining target member and (3) Production of Stack were changed to the following manners.
The copper paste was applied to the area of the copper lead frame (thickness: 2.0 mm) where a chip would be mounted, using a dispenser (S-SIGMA-CM3-V5 manufactured by Musashi Engineering, Inc.). Then, a 5 mm square SiC chip (thickness: 0.2 mm) as a second joining target member was placed on the applied copper paste such that the grounding surface of the SiC chip was in contact with the copper paste. The coating film after the SiC chip was placed thereon had a thickness of 50 μm. The copper paste spread over the entire area of the grounding surface of the SiC chip.

Example 6

A joined body was obtained in the same manner as in Example 5, except that in (1) Preparation of Paste, neodecanoic acid was added in an amount of 5.0% in 100% copper paste (i.e., 95.0% copper powders in 100% copper paste).

Example 7

A joined body was obtained in the same manner as in Example 5, except that in (1) Preparation of Paste, neodecanoic acid was added in an amount of 4.0% in 100% copper paste (i.e., 96.0% copper powders in 100% copper paste).

Comparative Example 1

A joined body was obtained in the same manner as in Example 1, except that neodecanoic acid was added such that the proportion of the total amount of the first copper powder and the second copper powder was 86.0% in 100% paste.

Comparative Example 2

A joined body was obtained in the same manner as in Example 1, except that neodecanoic acid was added such that the proportion of the total amount of the first copper powder and the second copper powder was 84.0% in 100% paste.

Joining Rate of Joining Layer

The joining rate of the joining layer was checked as a measure of suppression of void formation during sintering of the copper particles.

The joined bodies obtained in Examples and Comparative Examples were each observed from the back side of the copper lead frame by a reflection method using an ultrasonic flaw detector (model number: FineSAT III, manufactured by Hitachi Power Solutions Co., Ltd.) with a 75 MHz probe. When observing the state of delamination of the joining layer, the gain value was set to a value between 25 and 35 dB, and the delay and width of the S-gate were adjusted such that the peak position of the S-gate was at the surface of the copper lead frame. The delay of the F-gate was adjusted to specify the observation range of the joining layer, and the width thereof was set to a peak width of 1.5 wavelengths. The Z-axis coordinates of the probe were adjusted to maximize the amplitude of the observation peak, and observation was carried out. The contrast of the observation image was adjusted using an auto function.

The obtained image data was binarized using image processing software Image-J, and the percentage of a black area in the observation area was calculated. More specifically, after starting Image-J, "Analyze" -"Set measurement" was selected, and "Area", "Area fraction", "Limit to Threshold" were checked. Next, "File"-"Open" was selected, and image data for calculating of the joining rate was opened. Then, the range of the area where the SiC chip was mounted (hereinafter also referred to as "the range (A)") in the image was specified. Next, "Edit"-"Copy to system" was selected, and the range (A) was copied. Then, "File"-"New"-"System clipboard" was selected, and an image of the specified range (A) was pasted. Subsequently, in order to clarify the joined area, "Image"-"Type"-"8 bit" was selected to convert the image, and then, "Image"-"Adjust"-"Threshold" was selected to adjust the threshold of the image to 110. Then, the black range (B) present in the range (A), which was the area where the SiC chip was mounted, in the resulting image was specified. The black range (B) corresponded to the area where the SiC chip was joined. The joining rate is calculated from the formula: $(B)/(A)\times100$. A high joining rate indicates that void formation is suppressed.

Table 1

| | | Paste | | Evaluation |
|---|---|---|---|---|
| | | Proportion of total amount of copper powders (%) | Viscosity (Pa·s) | Joining rate (%) |
| | Ex. 1 | 92.5 | 171.98 | 88.3 |
| | Ex. 2 | 92.0 | 113.71 | 93.5 |
| | Ex. 3 | 90.0 | 50.75 | 90.9 |

(continued)

| | Paste | | Evaluation |
| --- | --- | --- | --- |
| | Proportion of total amount of copper powders (%) | Viscosity (Pa·s) | Joining rate (%) |
| Ex. 4 | 88.0 | 25.67 | 81.7 |
| Ex. 5 | 92.5 | 171.98 | 100.0 |
| Ex. 6 | 95.0 | 278.13 | 100.0 |
| Ex. 7 | 96.0 | 456.27 | 100.0 |
| Com. Ex. 1 | 86.0 | 13.99 | 61.9 |
| Com. Ex. 2 | 84.0 | 8.35 | 50.7 |

As is clear from the results shown in Table 1, the joined bodies obtained in Examples had higher joining rates than the joined bodies of Comparative Examples. It can be appreciated that, in the joined bodies obtained in Examples, sintering of the copper powder in the joining layer proceeded more and void formation was suppressed, as compared with the joined bodies obtained in Comparative Examples.

Although not shown in the table, the breaking strength of each of the joined bodies obtained in Examples was measured. A bond tester "Condor Sigma" manufactured by XYZTEC was used for the measurement. The breaking strength (MPa) is defined as breaking load (N)/joining area (mm$^2$). In all Examples, the breaking strength was more than 25 MPa, indicating that the joined bodies obtained in Examples were also excellent in the joining strength.

Industrial Applicability

As described in detail above, the present invention provides a copper paste for joining that is unlikely to generate voids that may be otherwise formed in sintering a coating film formed therefrom and can achieve a sufficiently high joining rate to a joining target member. More particularly, the present invention provides a copper paste for joining that is unlikely to generate voids and can achieve a sufficiently high joining rate even when the joining target members has a large joining area or when the joining is performed in a pressureless state.

**Claims**

1.    A copper paste for joining, comprising: two or more copper powders having different particle sizes; and a solvent,

wherein one of the copper powders has an increase rate of a crystallite size, (D2-D1)/D1×100, of 5% or more, where D1 (nm) represents a crystallite size at 150°C and D2 (nm) represents a crystallite size at 250°C, the solvent has a boiling point of 150°C or higher and lower than 300°C, and a proportion of a total amount of the copper powders is 88 mass% or more in 100 mass% of the copper paste.

2.    The copper paste for joining according to claim 1, wherein all the copper powders each have a spherical particle shape.

3.    The copper paste for joining according to claim 2,

wherein the copper powders include a first copper powder having a particle size d1 and a second copper powder having a particle size d2, and a ratio of the particle size of the second copper powder to the particle size of the first copper powder, d2/d1, is 2 or greater and 90 or less.

4.    The copper paste for joining according to claim 1, wherein a proportion of the copper powder having an increase rate of the crystallite size, (D2-D1)/D1×100, of 5% or more is 10 mass% or more and 80 mass% or less in 100 mass% of the total amount of the copper powders.

5.    The copper paste for joining according to claim 1, wherein the proportion of the total amount of the copper powders is 92 mass% or more in 100 mass% of the copper paste.

6. The copper paste for joining according to claim 1, wherein the copper paste is free from a solvent having a boiling point of 300°C or higher.

7. The copper paste for joining according to claim 1, having a viscosity of 10 Pa·s or more and 800 Pa·s or less, as measured at a shear rate of 10 s$^{-1}$.

8. The copper paste for joining according to claim 1, for joining target members to be joined having a joining area of more than 4 mm$^2$.

9. The copper paste for joining according to claim 1, for joining in a pressureless state.

10. A method for joining target members to be joined, the method comprising:

   laying two target members on top of each other with a joining area of more than 4 mm$^2$ via the copper paste for joining according to any one of claims 1 to 9, and
   sintering the copper paste in a pressureless state to join the two target members.

11. A method for producing a joined body, the method comprising:

   laying two target members to be joined on top of each other with a joining area of more than 4 mm$^2$ via the copper paste for joining according to any one of claims 1 to 9, and
   sintering the copper paste in a pressureless state to join the two target members.

12. A method for producing a copper paste for joining, the method comprising mixing copper powders and a solvent,

   wherein the copper powders comprise: a first copper powder having an increase rate of a crystallite size, (D2-D1)/D1$\times$100, of 5% or more, where D1 (nm) represents a crystallite size at 150°C and D2 (nm) represents a crystallite size at 250°C; and a second copper powder having a different particle size from the first copper powder, the solvent has a boiling point of 150°C or higher and lower than 300°C, and
   a proportion of a total amount of the copper powders is 88 mass% or more in 100 mass% of the copper paste for joining.

## INTERNATIONAL SEARCH REPORT

International application No.

**PCT/JP2023/015511**

### A.    CLASSIFICATION OF SUBJECT MATTER

***B22F 9/00***(2006.01)i; ***B22F 1/00***(2022.01)i; ***B22F 1/052***(2022.01)i; ***B22F 1/065***(2022.01)i; ***B22F 1/102***(2022.01)i; ***B22F 7/08***(2006.01)i; ***H01L 21/52***(2006.01)i

FI:    B22F9/00 B; B22F1/00 L; B22F1/052; B22F1/065; B22F7/08 C; H01L21/52 B; B22F1/102

According to International Patent Classification (IPC) or to both national classification and IPC

### B.    FIELDS SEARCHED

Minimum documentation searched (classification system followed by classification symbols)

B22F9/00; B22F1/00; B22F1/052; B22F1/065; B22F1/102; B22F7/08; H01L21/52

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| Y | JP 2019-2054 A (MITSUI MINING & SMELTING CO) 10 January 2019 (2019-01-10)<br>claims, paragraphs [0010]-[0011], [0016], [0020], [0026], [0029]-[0032], [0054], tables 1-3 | 1-12 |
| Y | JP 2014-167145 A (OSAKA UNIV) 11 September 2014 (2014-09-11)<br>paragraphs [0009], [0031]-[0032], [0036]-[0041], [0065], [0067] | 1-12 |
| Y | JP 2017-157329 A (MITSUI MINING & SMELTING CO) 07 September 2017 (2017-09-07)<br>paragraphs [0014], [0036] | 1-12 |
| Y | WO 2020/032161 A1 (MITSUI MINING & SMELTING CO) 13 February 2020 (2020-02-13)<br>paragraph [0037] | 7, 10-11 |

☐ Further documents are listed in the continuation of Box C.        ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **23 June 2023** | **04 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/015511**

| Patent document cited in search report | | | Publication date (day/month/year) | Patent family member(s) | Publication date (day/month/year) |
|---|---|---|---|---|---|
| JP | 2019-2054 | A | 10 January 2019 | (Family: none) | |
| JP | 2014-167145 | A | 11 September 2014 | (Family: none) | |
| JP | 2017-157329 | A | 07 September 2017 | (Family: none) | |
| WO | 2020/032161 | A1 | 13 February 2020 | US        2021/0138541      A1 paragraph [0051] EP              3834965      A1 CN          112437706      A KR  10-2021-0042081      A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180250751 A1